# EUROPEAN PATENT SPECIFICATION

(11) **EP 3 040 778 B1**
(45) Date of publication and mention of the grant of the patent: **30.09.2020**
(21) Application number: 14200632.9
(22) Date of filing: 30.12.2014
(51) Int. Cl.: G03F 7/20

(54) **Method for providing uniform brightness from a light projector on an image area.**
Vorrichtung zur Bereitstellung von gleichmäßiger Helligkeit aus einem Lichtprojektor auf einem Bild
Procédé pour fournir une luminance uniforme à partir d'un projecteur de lumière sur une zone d'image

(43) Date of publication of application: 06.07.2016
(73) Proprietor: VISITECH AS, 3003 Drammen (NO)
(72) Inventor: Jørgensen, Trond, N-3018 Drammen (NO); Kirkhorn, Endre, N-3031 Drammen (NO); Daae, John, N-1387 Asker (NO)
(74) Representative: Onsagers AS

(56) References cited:
- CA-A1- 2 888 844
- JP-A- 2011 066 087
- US-A1- 2001 035 944
- US-A1- 2006 098 263
- US-A1- 2007 284 547

## Description

Using electronic light projectors in lithography applications gives multiple advantages compared to traditional lithography systems using traditional technology such as contact film:
- The ability to change the artwork file to be exposed by changing only SW files instead of changing the physical film
- The ability to adjust the artwork outline (scale and rotate) to make it fit into the medium if there are any physical changes in the medium (e.g. for a multilayer PCB)
- The film will get worn out after a certain use due to e.g. temperature, while exposure using electronic projectors can be used in an almost unlimited cycles

Typical lithography applications where electronic projectors can be utilized are:
- Manufacturing of electronic devices , such as printed circuit boards, touch panels and microelectronic circuits
- 3D rapid manufacturing and prototyping machines, also called 3D printers.

For 3D rapid manufacturing applications, electronic projectors have been utilized for a longer period of time than for manufacturing electronic devices. This is mainly because of two reasons:
- Exposure area is traditionally larger for electronic devices with panel sizes up to 1 m²
- The object size for the electronic devices is smaller, meaning that the resolution is higher

The exposure area is a matter of the size of the projected image. An increased image size will give larges pixel size and reduce the resolution. This is more acceptable for 3D rapid manufactured products than for electronic devices.

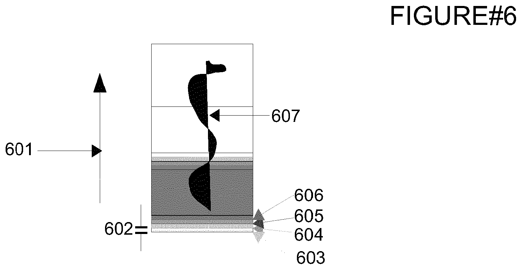

One way of achieving large exposure areas while still maintaining high resolution is to move one or multiple electronic light projectors over the medium while exposing with a small image. Figure 6 shows an example of such a process.

Each time the relative position between the exposure unit and the medium has moved a distance corresponding to one or multiple pixel row(s) in the exposure image, a trigger signal is imposed from the motion controller towards the exposure unit. Thus, a new image is set up on the exposure unit. This method is often referred to as image scrolling, as the exposed pattern visually seems to scroll over the medium.

In applications where static electronic light projectors have been utilized (as in traditional 3D rapid manufacturing applications), each point in the medium receives the light energy from one particular pixel from the electronic light projector. The amount of energy received is defined by the period of time the light is present. In image scrolling applications, each point in the medium receives light energy pulses from all the pixels in a column of pixels in the image. The total energy received by the point in the medium is equal to the sum of light energy of all these light pulses from the column of pixels.

Common for all these applications is that the brightness uniformity of the light in the image needs to be good to achieve correct exposure quality on the medium. For example will a non-uniform brightness distribution cause more energy to be provided to some parts of the image than other parts. When exposing on photo polymerized materials, this means that some parts will be exposed faster than other parts, or even overexposed. For PCB lithography this will cause lines to be thicker at over-exposed areas than less exposed areas. This is not desired.

For applications where static electronic light projectors are utilized, patented methods have been developed. These techniques include using a superimposed greyscale image to compensate for brightness non-uniformities. After compensation, each of the pixels in the exposed image will deliver the same light energy to the medium. In electronic light projectors utilizing DLP technology, grey scale images are achieved using time multiplexing techniques, where the pixel mirrors on the DMD are switched on and off at a high frequency.

However, for image scrolling applications, this grey scale technique cannot be utilized, as the frame rate (switching frequency) for the pixel mirrors is already close to maximum allowable for the DMD when the images are scrolling at a high speed. High speed causes the trigger pulses to be imposed into the exposure unit at a high rate from the motor controller. As each trigger pulse causes a new image to be set up on the DMD, the DMD frame rate will be very high. The scrolling speed is related to the light energy sensitivity for the medium. For stereolithography(3D) applications, this is in the range of 10-20mJ/cm², while for PCB lithography this varies from 10-50mJ/cm². If the light power is within the range of 2-3W, the speed will be approx 400mm/s giving a frame rate of up to 19kHz if the pixel size is approximately 11µm. This is very close to maximum framerate for a DMD. This implies that the DMD cannot support greyscale during image scrolling, as the greyscale is created by providing light patterns with variable duration, Pulse Width Modulation (PWM). In order to create greyscale at a frame rate of 19kHz, each of the image frames must have a subset of images lasting down to 1/256 of the time for the complete main frame (for a 8 bit grey scale level), requiring a frame rate of 4.9MHz, which is far above the maximum frame rate of a DMD.

As each point in the medium experience light energy from all pixels in an image column, the non-uniformity in light energy between the pixel columns (1 - dimensional) needs to be compensated rather than the non-uniformity in light energy between each pixel in the exposure image (2 dimensional), which is the case for traditional greyscale brightness uniformity techniques. This is especially important when subpixelation techniques are implied:
In order to achieve resolution higher than the native pixel size, different techniques that implies use of scrolling is utilized. High resolution is required for especially PCB lithography applications, as linewidths are constantly decreasing while the speed requirement (throughput) is always high, implying that exposure image size cannot be too small. When such subpixelation techniques are applied, such as the one described in EP 2 056 165 A1 and related patents, the image is divided into subimages (Figure 4). It is important that all subimages experience equal brightness uniformity compensation. This is can only be applied when each column in the exposed image is compensated rather than if each pixel in the exposed image is compensated.

CA 2 888 844 A1 discloses a method for producing a homogenized light quantity distribution with a spatial light modulator, which has a plurality of addressable, tiltable micromirrors arranged in rows and columns, in which the light from a flood light source is projected by an optical system and an illumination pattern of the projected light source is guided over a projection surface, wherein a plurality of pixels increasing in number towards the centre of the image are not illuminated so that homogenization of the light intensity of all pixels illuminated on the projection surface is achieved over a time integral.

The invention will now be described by means of examples and by reference to the accompanying figures.
Figure 1 illustrates a measurement setup for a method for providing uniform brightness from a light projector on an image area to be exposed.
Figure 2 shows further details of the method of figure 1.
Figure 3 illustrates details of a step of the method of figure 1.
Figure 4 shows an example a sub profiling process.
Figure 5 illustrates an image scrolling process.
Figure 6 illustrates the building of the image in an image scrolling process.

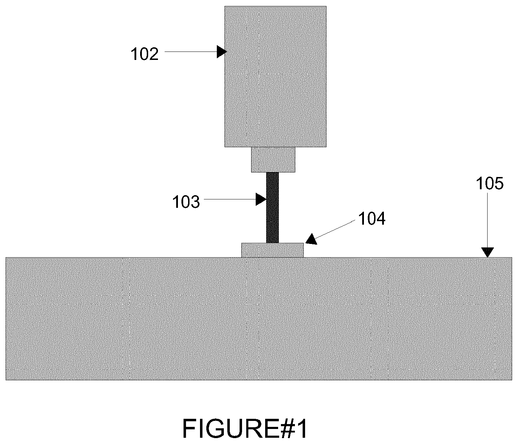

Figure 1 illustrates an example of a method for providing uniform brightness from a light projector on an image area to be exposed. It comprises a measurement setup to capture the brightness uniformity characteristics of the electronic image projector 102. The projected light beam of a white image 103 creates an image captured by the CCD camera or light power meter 104 in the focal plane placed on the exposure table 105. This first image represents the brightness distribution over the image area. This first step of the measurement method can also be used for traditional grey scale brightness uniformity techniques

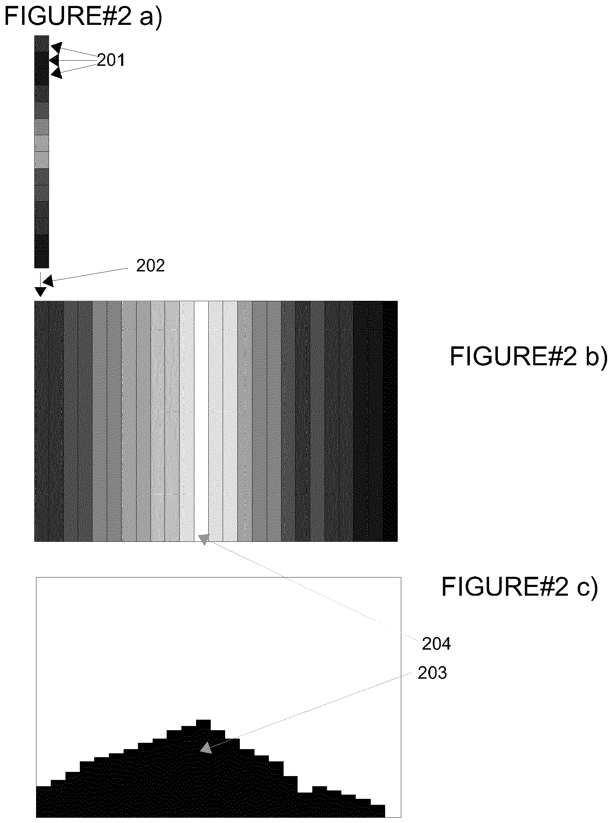

The method is further visualized in Figures 2a to 2d. Figure 2a and 2b describes a visualization of the different measured brightness levels 201 along the length of the column of the white image captured by the CCD camera or light power meter in Figure 1. All measured brightness levels for each column, here exemplified with 25 columns, is averaged 202.

Figure 2c describes the static overlay image, where the height of each black column 203 reflects the averaged brightness level for the corresponding column 204 on the captured image. If the average brightness level for a column is low, the height of the black column in the resulting static image is small.

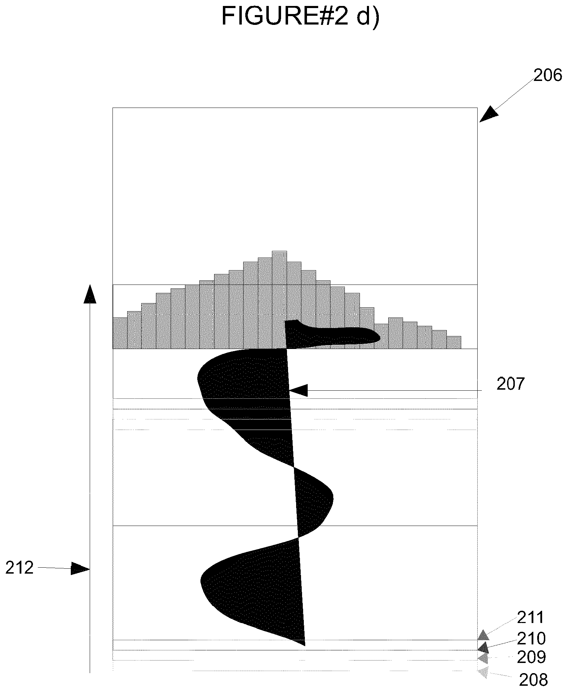

At the reception of a trigger signal, a new image is set up on the exposure unit thus changing from exposed image#1 208 to exposed image#2 209 etc, as illustrated in Figure 2d. It describes the image scrolling process where the exposed pattern 207 is exposed on to the media during image scrolling. Each image displayed on the DMD (here visualized with 4 images 208- 211) is exposed on to the media while the electronic light projector is moved relative to the media along the scroll axis 212 synchronized with the motion speed. Each of the images (visualized in 208-211) experiences a static image overlay 206 stored in the electronic light projector reflecting the brightness uniformity. The height of each of the black columns in the static overlay image will determine how much light energy that will be exposed on to the media for the resulting column. Hence, the brightness non-uniformity will be compensated after each of the images has scrolled over the static overlay image.

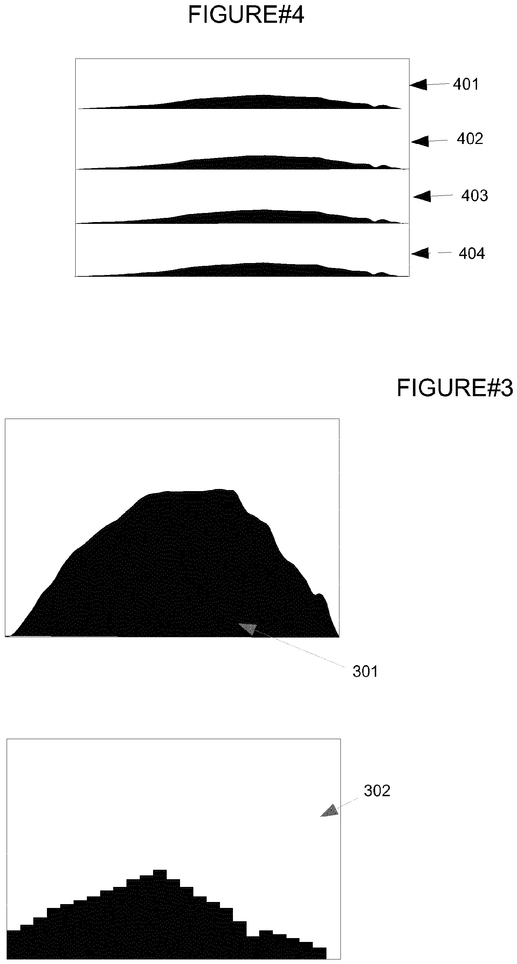

Depending on the image resolution and the dynamic range of the image non-uniformity, the column resolution can be varied. If the brightness non-uniformity is severe, ie. the large dynamic range of non-uniformity will require a higher column resolution than if the brightness uniformity is less severe. The increased resolution, ie. thinner columns, leads to less brightness differences between the columns, and thus better uniformity in the resulting image. This is described in Figure 3. Here, 301 describes a static overlay image with high density (a high number of columns). This is required when the brightness uniformity in the system is poor with high dynamic range. 302 describes a static image overlay with less number of columns, which can be used for better brightness uniformity systems with lower dynamic range.

When used in combination with Optical Multiplexing, it is required to divide the static brightness overlay image profile into multiple sub profiles, so that each of the columns in each of the sub profiles experience correct brightness level to achieve correct image uniformity. Figure 4 shows an example of such a sub profiling process with four sub profiles. Adding the four sub profiles 401 - 404 will give the initial brightness image profile of figure 2c.

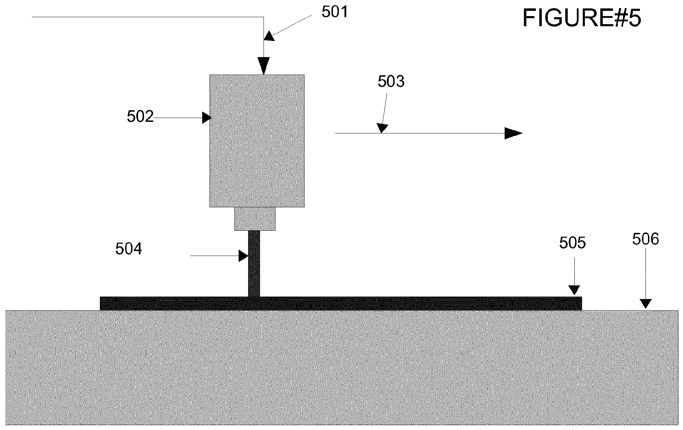

Figure 5 illustrates an image scrolling process. This is a way of achieving large exposure areas while still maintaining high resolution. In this example, an electronic light projector 502 is arranged to move over the medium 505 to be exposed, which is arranged on an exposure table 506. During this movement, the projected light beam 504 from the light projector is exposing a small image. The arrow 503 shows the relative motion direction between the electronic light projector 502 and the medium 505. In other embodiments there may be more than one light projector projecting simultaneously, for example in parallel. The medium 505 to be exposed is in this embodiment a photo polymerized material, but may be other types of photosensitive materials.

The relative motion between the light projector and the medium may be achieved by moving the light projector while the medium is fixed in position or vice versa. In figure 5 it is the light projector which moves and the exposure medium is in fixed position. The light projector or a bearing mount for the light projector receives a motion signal from a motor controller 501, controlling the relative movement between the projector 502 and the medium 505. Each time the relative position between the exposure unit and the media has moved a distance corresponding to one pixel row in the exposure image, a trigger signal is imposed from the motion controller towards the light projector.

Figure 6 illustrates the building of the image in an image scrolling process. Each time the relative position between the electronic light projector and the light sensitive medium has moved along the scroll axis 601 distance corresponding to one pixel row 602 in the exposure image, a trigger signal is imposed from the motion controller towards the electronic light projector. Thus, a new image is set up on the exposure unit (changing from one exposed image 603 to the next 604, 605, 606 etc). This method is often referred to as image scrolling, as the exposed pattern 607 visually seems to scroll over the light sensitive medium along the scroll axis 601.

## Claims

1. Method for providing uniform brightness from a light projector (102) on an image area to be exposed in direct imaging lithography applications, the method comprising the following steps;
- capturing a first image from the light projector representing the brightness distribution over the image area,
- subdividing the first image into a number of columns (204)
- calculating an averaged brightness value for each column,
- creating a brightness image profile, wherein, if the image to be exposed is divided in sub images for higher resolution, the brightness image profile is subdivided into a number of image sub profiles (401, 402, 403, 404) corresponding to the number of sub images, and
- superimposing the brightness image profile on the image to be exposed by the light projector.

2. Method according to claim 1, wherein the brightness image profile provides a static overlay image to the light projector.

3. Method according to claim 1, where the first image is captured by means of a CCD camera or light power sensor (104) arranged in the focal plane of the light projector, and the captured image is transferred to the light projector for the subsequent steps.

4. Method according to claim 1, where the light projector is a spatial light modulator, such as a dmd device.

5. Method according to claim 1, where the brightness image profile represents the time period for each column where the light projector will not emit any light to the image area.

6. Method according to claim 1, where the width of the columns depend on the dynamic range of the brightness distribution.

7. Method according to claim 1, where the columns have a width of 100 pixels.

## Patentansprüche

1. Verfahren zum Bereitstellen einer gleichmäßigen Helligkeit von einem Lichtprojektor (102) auf einem Bildbereich, der bei Direktabbildungs-Lithographieanwendungen belichtet werden soll, wobei das Verfahren die folgenden Schritte umfasst:
Aufnehmen eines ersten Bildes von dem Lichtprojektor, das die Helligkeitsverteilung über den Bildbereich darstellt,
Unterteilen des ersten Bildes in eine Anzahl von Spalten (204),
Berechnen eines gemittelten Helligkeitswertes für jede Spalte,
Erzeugen eines Helligkeitsbildprofils, wobei, wenn das zu belichtende Bild für eine höhere Auflösung in Unterbilder unterteilt wird, das Helligkeitsbildprofil in eine Anzahl von Bildunterprofilen (401, 402, 403, 404) entsprechend der Anzahl von Unterbildern unterteilt wird, und
Auflagern des Helligkeitsbildprofils auf das durch den Lichtprojektor zu belichtende Bild.

2. Verfahren nach Anspruch 1, wobei das Helligkeitsbildprofil ein statisches Überlagerungsbild für den Lichtprojektor liefert.

3. Verfahren nach Anspruch 1, wobei das erste Bild mit Hilfe einer CCD-Kamera oder eines Lichtleistungssensors (104) aufgenommen wird, der in der Brennebene des Lichtprojektors angeordnet ist,
und das aufgenommene Bild für die nachfolgenden Schritte auf den Lichtprojektor übertragen wird.

4. Verfahren nach Anspruch 1, wobei der Lichtprojektor ein räumlicher Lichtmodulator, wie beispielsweise eine DMD-Vorrichtung, ist.

5. Verfahren nach Anspruch 1, wobei das Helligkeitsbildprofil die Zeitspanne für jede Spalte darstellt, in der der Lichtprojektor kein Licht in den Bildbereich emittiert.

6. Verfahren nach Anspruch 1, wobei die Breite der Spalten vom Dynamikbereich der Helligkeitsverteilung abhängt.

7. Verfahren nach Anspruch 1, wobei die Spalten eine Breite von 100 Pixeln aufweisen.

## Revendications

1. Procédé d'obtention d'une luminosité uniforme à partir d'un projecteur (102) sur une zone d'image à exposer dans des applications à lithographie d'imagerie directe, ce procédé comprenant les étapes suivantes :
- capture d'une première image provenant du projecteur représentant la distribution de la luminosité sur la zone de l'image,
- la subdivision de la première image en plusieurs colonnes (204),
- le calcul d'une valeur de luminosité moyennée pour chaque colonne,
- la création d'un profil d'image de luminosité, dans lequel, si l'image à exposer est divisée en sous-images pour une résolution plus élevée, le profil d'image de luminosité est subdivisé en un nombre sous-profils d'image (401, 402, 403, 404) correspondant au nombre de sous-images et
- la surimposition du profil d'image de luminosité sur l'image à exposer par le projecteur.

2. Procédé selon la revendication 1, dans lequel le profil d'image de luminosité fournit une image de superposition statique avec le projecteur.

3. Procédé selon la revendication 1, dans lequel la première image est capturée au moyen d'une caméra CCD ou d'un capteur de puissance lumineuse (104) disposé dans le plan focal du projecteur et l'image capturée est transférée au projecteur pour les étapes suivantes.

4. Procédé selon la revendication 1, dans lequel le projecteur est un modulateur de lumière spatial tel qu'un dispositif dmd.

5. Procédé selon la revendication 1, dans lequel le profil d'image de luminosité représente la période pour chaque colonne dans laquelle le projecteur n'émet pas de lumière vers la zone d'image.

6. Procédé selon la revendication 1, dans lequel la largeur des colonnes dépend de la portée dynamique de la distribution de luminosité.

7. Procédé selon la revendication 1, dans lequel les colonnes présentent une largeur de 100 pixels.
